# EUROPEAN PATENT SPECIFICATION

(11) **EP 4 505 606 B1**
(45) Date of publication and mention of the grant of the patent: **19.08.2026**
(21) Application number: 23715500.7
(22) Date of filing: 28.03.2023
(51) Int. Cl.: H03K 17/96

(54) **A METHOD FOR ASCERTAINING A MANUAL EXERTION OF A CAPACITIVE SENSOR DEVICE, A COMPUTER PROGRAM PRODUCT AND AN ASCERTAINING DEVICE FOR ASCERTAINING A MANUAL EXERTION OF A CAPACITIVE SENSOR DEVICE**
VERFAHREN ZUR ERMITTLUNG EINER HANDBELASTUNG EINER KAPAZITIVEN SENSORVORRICHTUNG, COMPUTERPROGRAMMPRODUKT UND ERMITTLUNGSVORRICHTUNG ZUR ERMITTLUNG EINER HANDBELASTUNG EINER KAPAZITIVEN SENSORVORRICHTUNG
PROCÉDÉ DE DÉTERMINATION D'UN EFFORT MANUEL D'UN DISPOSITIF CAPTEUR CAPACITIF, PRODUIT PROGRAMME D'ORDINATEUR ET DISPOSITIF DE DÉTERMINATION POUR DÉTERMINER UN EFFORT MANUEL D'UN DISPOSITIF CAPTEUR CAPACITIF

(30) Priority: 01.04.2022 DE 102022107844
(43) Date of publication of application: 12.02.2025
(73) Proprietor: Valeo Schalter und Sensoren GmbH, 74321 Bietigheim-Bissingen (DE)
(72) Inventor: SEGUIN, David, 94000 Creteil (FR)
(74) Representative: Ralf, Thorge
(86) International application number: PCT/EP2023/057944
(87) International publication number: WO 2023/186868

(56) References cited:
- US-B2- 10 241 147
- US-B2- 9 465 001

## Description

The invention relates to a method for ascertaining a manual exertion of a capacitive sensor device, wherein at least one capacitive sensor element of the capacitive sensor device is exposed to a sinewave-based first electric signal, wherein the at least one capacitive sensor element provides a second electric signal in response to exposition with the first electric signal, wherein the second electric signal is input to an in-phase-detector, in order to provide an I-signal in response to the second electric signal, and a quadrature-phase-detector, in order to provide a Q-signal in response to the second electric signal, wherein the I-signal and the Q-signal are processed by a determination apparatus in order to ascertain the manual exertion. Moreover, the invention relates to a computer program product as well as an ascertaining device for ascertaining a manual exertion of a capacitive sensor device, wherein the ascertaining device is configured to be coupled to at least one capacitive sensor element of the capacitive sensor device, the ascertaining device comprising: a signal generator for generation a sinewave-based first electric signal, wherein the signal generator is further configured to expose the at least one capacitive sensor element of the capacitive sensor device to the first electric signal, a receiving apparatus configured to receive a single electric signal from the at least one capacitive sensor element provided in response to exposition with the first electric signal, an in-phase detector coupled with the receiving apparatus, wherein the in-phase-detector is configured to determine an I-signal in response to the second electric signal, a quadrature-phase-detector coupled with the receiving apparatus, wherein the quadrature-phase-detector is configured to determine a Q-signal in response to the second electric signal, and a determination apparatus coupled with the in-phase-detector and the quadrature-phase-detector, wherein the determination apparatus is configured to process the respective I-signal and the respective Q-signal of the second signal of the at least one capacitive sensor element, in order to allow ascertaining the manual exertion.

Generic methods, computer program products and ascertaining devices are well known in the art, which is why it is not necessary to recite a related specific state of the art. They are usually used to allow ascertaining a manual exertion of the capacitive sensor device, especially, a manual exertion of the at least one capacitive sensor element. This is useful for controlling functions of appliances such as a vehicle, especially a car, a ship, an airplane and/or the like, as well as controlling machineries of plants, household devices and so on. The use of the capacitive sensor device allows simple manipulation and controlling of the before-mentioned appliances. Usually, the capacitive sensor device can be touched by a part of a body of a user such as a finger, a hand, or the like. The ascertaining device, which is electrically connected with the capacitive sensor device, especially with its at least one capacitive sensor element, receives respective signals from the capacitive sensor device or the at least one capacitive sensor element, processes these signals and ascertains the manual exertion or manual actuation, respectively. The ascertaining device may output a respective signal for controlling purposes as detailed above.

US 10 241 147 B2 discloses a complex impedance measurement circuit for a sense-only capacitive sensor operated in loading mode.

Unfortunately, it has been found that the state of the art is prone to some deficiencies.

Especially, capacitive sensor devices suffer from being prone to humidity, pollution, environmental effects and the like, which may affect the reliability of the ascertaining device for ascertaining a manual exertion.

Therefore, the technical object of the invention is to improve a generic method, and an ascertaining device such that it can be more stable with regard to temperature, humidity, environmental effects and/or the like, as well as providing a respective computer program product.

As a solution with regard to the before-mentioned technical object, a method, a computer program product and an ascertaining device according to the independent claims is proposed.

Preferable embodiments can be derived from the features of the dependent claims.

With regard to a generic method, it is proposed that at least three predetermined reference impedances are also exposed to the first electric signal, wherein the at least three predetermined reference impedances provide respective second electric reference signals which are input to the in-phase-detector and the quadrature-phase-detector, in order to provide respective reference I-signals and respective reference Q-signals, wherein the I-signal and the Q-signal of the second electric signal of the at least one capacitive sensor element, the reference I-signals and the reference Q-signals are processed by the determination apparatus, in order to ascertain the manual exertion additionally depending on the reference I-signals and the reference Q-signals.

With regard to a computer program product, it is proposed that the computer program product includes a program for a computing apparatus, comprising software code portions of a computer program for performing the steps of the inventive method, when the computer program is run on the computing apparatus.

With regard to a generic ascertaining device, it is proposed, that the ascertaining device is further configured to be coupled to at least three predetermined reference impedances, wherein the signal generator is configured to expose the at least three predetermined reference impedances to the first electric signal and the receiving apparatus is configured to receive respective second electric reference signals from the at least three predetermined reference impedances supplied to the in-phase-detector and the quadrature-phase-detector, in order to provide respective reference I-signals and respective reference Q-signals, wherein the determination apparatus is further configured to process the I-signal and the Q-signal of the second electric signal of the at least one capacitive sensor element, the reference I-signals and the reference Q-signals, in order to allow ascertaining the manual exertion additionally depending on the reference I-signals and the reference Q-signals.

Without limitation, the invention is based on the finding that ascertaining the manual exertion can be improved if known reference impedances or predetermined reference impedances, respectively, are considered during processing of the at least one second signal for ascertaining the manual exertion. In this regard, the inventive concept is not limited only to one single capacitive sensor element, especially, the capacitive sensor device may comprise more than one single capacitive sensor element, for example, two, three, four, or the like capacitive sensor elements, which are preferably all connected with the ascertaining device in order to ascertain manual exertion. In this regard, the capacitive sensor elements may be provided such as a metal sheet, a plate, a mat of capacitive sensor elements or the like so that, for instance, a position of manual exertion on the metal sheet or plate can be detected. Such a mat of capacitive sensor elements can be used, for example, for a providing a hands-on-device (HOD) for a steering wheel of the vehicle or the like. However, plural further applications can be considered without leaving the scope of the invention.

Although the ascertaining device may be a separate component which may be electrically coupled with the capacitive sensor device, both of these devices may at least partially combined in order to form a unitary component or the like. Preferably, the ascertaining device may comprise an electronic circuitry, such as a hardware circuitry. It may also comprise a computing apparatus, which may be controlled by a respective computer program. The electronic circuitry may be formed at least partially by an integrated circuit.

The ascertaining device includes the signal generator which is configured to generate a sinewave-based first electric signal. The first electric signal is supplied to the at least one capacitive sensor element. If more than one single capacitive sensor element is provided, it is possible to supply the first electric signal to all of the capacitive sensor elements at the same time. However, it is also possible that the first electric signal is multiplexed so that only one single capacitive sensor element is exposed to the first electric signal for a predetermined time interval.

The first electric signal can be provided as a continuous wave signal. However, it may also be provided as a pulse, a burst, or the like. Also combinations of the before-mentioned possibilities can be considered.

The receiving apparatus is configured to receive the second signal from the at least one capacitive sensor element provided in response to exposition with the first electric signal. If the capacitive sensor device has more than one single capacitive sensor, multiplexing or parallel processing can be provided. Generally, the second electric signal is a response of the respective capacitive sensor element when exposed to the first electric signal. This response depends on the presence of manual exertion or actuation, for example, a touch of a finger of the user, a touch of a hand of the user, combinations thereof or the like.

Unfortunately, interfering effects, for example, depending on temperature, humidity or the like may also influence the second electric signal. Therefore, the second electric signal is processed by the ascertaining device, in order to reduce the interfering effects. This is possible or can be enhanced by the use of the at least three predetermined reference impedances. The values of the at least three predetermined reference impedances are known to the ascertaining device. This can be achieved by inputting the values of the at least three predetermined reference impedances by an input device, by submitting a file having the at least three predetermined reference impedances to the ascertaining device or the like. At the same time, respective inputs of the ascertaining device, which are connected with the predetermined reference impedances, can be processed similar to the processing of the second electric signal so that, by comparing the processing results with the respective known values, the interferences can be more precisely determined and considered during processing the second electric signal.

If more than one capacitive sensor element is provided, there will be processed a respective number of second electric signals respective to the number of the capacitive sensor elements.

The at least one second electric signal and a second electric reference signals are processed in order to receive respective I-signals and respective Q-signals as well as respective reference I-signals and respective Q-signals. This can, for instance, be achieved by respective in-phase-detectors and quadrature-phase-detectors. Also multiplexing can be provided in this regard.

According to the invention, the determination apparatus processes the I-signal and the Q-signal of each of the second signals of the capacitive sensor elements, wherein considering especially results with regard to interferences, which are resulted by additionally processing the reference I-signals and the reference Q-signals. Hence, reduction of the interferences can be achieved so that, at the same time, reliability of ascertaining the manual exertion can be enhanced. Consequently, the invention allows improving the ascertaining of the manual exertion.

In order to realize respective processing, a control apparatus can be provided which can be based on electronic hardware and/or a computer apparatus which operation is controlled by a respective computer program. The control apparatus and/or the computer apparatus can provide the functions of at least one or more of the apparatuses according to the invention, for instance, the signal generator, the receiving apparatus, the in-phase-detector, the quadrature-phase-detector, the determination apparatus and/or the like.

According to an exemplary embodiment, it is proposed that the first electric signal is a voltage-based signal and the second electric signal is a current-based signal. Therefore, the signal generator may provide the first signal as a voltage signal which is supplied to the respective capacitive sensor element and the respective reference impedances. The at least one capacitive sensor element as well as the reference impedances react or response by providing a respective current signal, which may be detected by the receiving apparatus. For this purpose, the receiving apparatus may have one or more respective current sensors, which can be used for measuring the current of one or all of the capacitive sensor elements and the reference impedances. The receiving apparatus receives the respective current signals as the respective second signals or the receiving apparatus may transform the respective current signals to, for example, respective voltage signals which may form the respective second signals. In this regard, an easy implementation for the invention can be achieved.

It may be further advantageous, when the first and the second signals are analogue signals. This allows a precise relation between the first signal and respective the second signal. The expense for processing the second signals can be simplified.

According to an exemplary embodiment, each of the reference impedances comprises a resistive part and a reactive part. Generally, it is possible that a specific resistive part or a specific reactive part may have a value of about zero or may have a value of about ad infinitum. It is also possible for at least one of the reference impedances that not only the reactive part has a value of about ad infinitum but also the reactive part has a value of about ad infinitum. Preferably, some of the reference impedances have reasonable values for the resistive part and the reactive part. For example, a reference impedance may be provided by a circuitry comprising at least one electric resistor and at least one electric capacitor. These electronic components may be connected in parallel or in series. However, the circuitry may also include more than only one of the before-mentioned electronic elements. For example, it may comprise an electronic inductivity. Preferably, the reference impedances differ from each other. This may improve the function of the invention.

According to a preferred embodiment, at least a value of the resistive part or the reactive part of one of the reference impedances differs from the respective values of the resistive part or the reactive part, respectively, of one of the other reference impedances. This allows to span a virtual plane by the reference impedances, on which basis transforming of the I-signal and the Q-signal of the second signal of the at least one capacitive sensor element such that the interferences can be realized. This may support to improve the operation of the invention.

According to a further exemplary embodiment, it is proposed that the in-phase-detector processes the second electric signal such that an in-phase signal portion of the second electric signal is determined for providing the I-signal. The in-phase-detector may provide an operation, for example, by using mathematic formulas, in order to determine the in-phase portion of the second signal with regard to the first signal. This in-phase portion may be used as the I-signal.

It is further proposed that the quadrature-phase-detector processes the second signal such that a quadrature-phase signal portion of the second signal is determined for providing the Q-signal. In this regard, similar to the in-phase-detector, the quadrature-phase-detector may determine a signal portion of the second signal such that this portion is orthogonal to the first signal. Preferably, it may be a signal portion that has a phase difference of about π/2. This signal portion may form the Q-signal. Preferably, the I-signal and the Q-signal can be determined such that a square value of the I-signal plus a square value of the Q-signal corresponds to a square value of the second signal.

For the purpose of determining the I-signal and the Q-signal, a combination of the second electric signal and the first electric signal can be provided, for example by multiplying, comparing, further operations and/or the like.

The invention may further include a transform apparatus. At least one parameter of the transform apparatus is preferably determined dependent on the reference I-signals, the reference Q-signals and the respective values of the predetermined reference impedances. As discussed above, the values of the predetermined reference impedances may be provided by a file, as hardware or the like. Also, there may be an input device for inputting the respective values. The transform apparatus calculates the respective values of the reference impedances and the respective reference I-signals and the respective reference Q-signals such that parameters can be determined. These parameters can be used by the transform apparatus for processing the I-signal and the Q-signal of the second signal of the at least one capacitive sensor element in order to receive a respective capacity value and a respective conductivity value. Therefore, the transform apparatus provides a respective transform, in order to transform the I-signal and the Q-signal to a respective capacitance value and a respective conductivity value. Based on these values, which are less prone to interferences, the determination apparatus can further improve determination of manual exertion.

In order to further improve the invention, in an additional exemplary embodiment, the reference I-signals and the reference Q-signals are subjected to an offset compensation. The offset compensation allows reducing undesired side effects, which may affect the ascertaining process. The offset compensation can be a DC-offset homogenisation. It may especially include a thermal compensation.

Moreover, according to a further exemplary embodiment, it is proposed that the I-signal and the Q-signal of the second electric signal of the at least one capacitive sensor element is processed by the transform apparatus, in order to determine a respective capacitance value and a respective conductivity value with regard to the second electric signal of the at least one capacitive sensor element. By use of the transform apparatus, the ascertaining process, especially processing by the determination apparatus, can be improved. The result, especially the respective capacitance value and the respective conductivity value, allows improving the reliability with regard to the ascertaining of the manual exertion. For this purpose, the transform apparatus may use the parameters which were determined in advance to processing the I-signal and the Q-signal.

Moreover, it is proposed that the I-signal and the Q-signal of the second electric signal of the at least one capacitive sensor element are subjected to the offset compensation. This may further improve the reliability, as disturbances caused by the offset can be reduced. The offset compensation can be similar to the offset compensation of the reference signals and the reference Q-signals as discussed above. For example, the offset compensation can be provided by a specific offset compensation apparatus, which may be used for both, the reference I-signals and the reference Q-signals as well as the I-signals and the Q-signals of the second signal of the at least one capacitive sensor element.

According to a further embodiment, the manual exertion is ascertained based on the respective capacitance value and the respective conductivity value related to the second electric signal of the at least one capacitive sensor element. As discussed above, the reliability can be improved.

According to another preferred embodiment, the ascertaining device may comprise a housing with at least four input terminals configured to be connected with a respective one of the at least three reference impedances and the at least one capacitive sensor element of the capacitive sensor device. Preferably, the ascertaining device may have for each of the reference impedances and the capacitive sensor elements a specific single input terminal. Also, it can be considered that a reference impedance or a capacitive sensor element may require two or more input terminals. Also combinations thereof can be possible. This allows for very flexible adaptions of the capacitive sensor device.

Advantages and effects recite with regard to the inventive method also apply to the inventive computer program product and the inventive ascertaining device, and vice versa. Consequently, method features can be recited as respective apparatus features, and vice versa.

Further features of the invention are apparent from the claims, the figures and the description of figures.

In the figures show:
- Fig. 1: a schematic block diagram of a first portion of an ascertaining device having an electronic circuitry connected with capacitive sensor elements of a capacitive sensor device, wherein only one single capacitive sensor element of a capacitive sensor device is shown, wherein the circuitry provides a respective I-signals and a respective Q-signals, in order to allow ascertaining manual exertion of the capacitive sensor elements,
- Fig. 2: a schematic block diagram of a second portion of the ascertaining device having an electronic circuitry processing the I-signals and the Q-signals, in order to determine a respective capacitance values and a respective conductivity values,
- Fig. 3: a schematic flow chart showing the inventive method,
- Fig. 4: a portion of the schematic block diagram of a portion of the ascertaining device according to Fig. 1, which is realized by an integrated circuit, wherein four reference impedances and one example of the capacitive sensor elements are connected with the integrated circuit,
- Fig. 5: a schematic diagram showing parameters of the I-signal and the Q-signal depending on a value of a specific impedance of the capacitive sensor elements and reference impedances, and
- Fig. 6: a schematic diagram showing parameters according to Fig. 5, wherein each parameter is related to a capacitance value and a conductance value by using a transform apparatus.

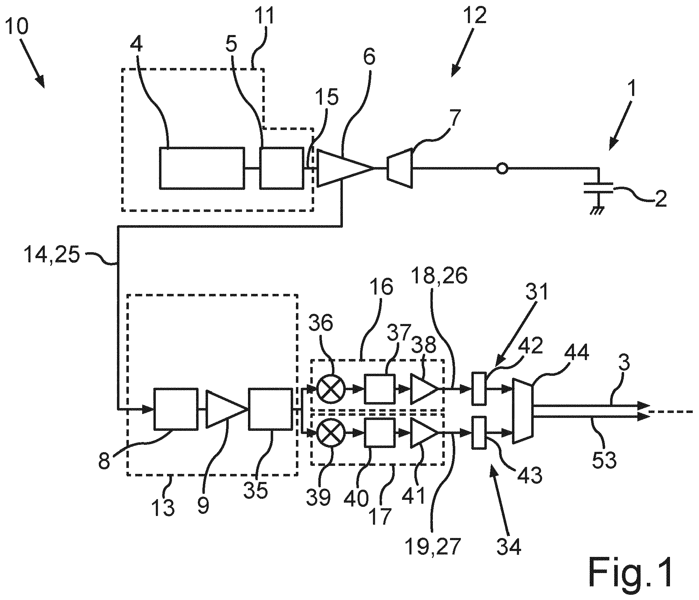

Fig. 1 shows in a schematic block diagram a first portion of an ascertaining device 10, which is connected to a capacitive sensor device 1 comprising plural capacitive sensor elements 2. The capacitive sensor elements 2 form a sensor mat (not shown), which can be arranged at a steering wheel of a vehicle, in order to allow detection of hands-on-wheel. In Fig. 1, only one capacitive sensor element 2 is shown. However, the invention does not depend on the number of the capacitive sensor elements 2. At least one capacitive sensor element 2 needs to be necessary.

The ascertaining device 10 comprises a signal generator 11 for generating a sine wavebased first electric signal 15, which is a voltage signal in this embodiment. The signal generator 11 is configured to expose the capacitive sensor elements 2 of the capacitive sensor device 1 to the first electric signal 15. The signal generator 11 comprises an oscillator 4, which generates the first electric signal 15 with a predetermined frequency and amplitude. This signal passes a low-pass filter 5 of the signal generator 11 and an intersection 6 of the ascertaining device 10. Then, the first signal 15 is input to a multiplexer 7, which multiplexes the first signal 15, in order to distribute the first signal 15 to every of the capacitive sensor elements 2 of the capacitive sensor device 1.

Every capacitive sensor element 2 provides, in response to exposition with the first signal 15, a second signal 14, which is presently a current signal. The second signal 14 passes the multiplexer 7 and the intersection 6 so that it can be received from a receiving apparatus 13 of the ascertaining device 10.

The receiving apparatus 13 is configured to receive every second electric signal 14 from each of the capacitive sensor elements 2. The second electric signal 14 then passes a low-pass filter 8 of the receiving apparatus 13, and is then conveyed to an amplifier 9. The second electric signal 14 passes then a band pass 35 of the receiving apparatus 13.

As can be seen from Fig. 1, the receiving apparatus 13, especially the band pass 35, is further coupled with an in in-phase-detector 16. The in-phase-detector 16 is configured to determine an I-signal 18 in response to the second electric signal 14. The in in-phase-detector 16 processes the second electric signal 14 such that an in-phase signal portion of the second electric signal 14 is determined for providing the I-signal 10. The in-phase-detector 16 is comprised by the ascertaining device 10. The in in-phase-detector 16 comprises a demodulation portion 36, in order to determine a signal portion of the second electric signal 14, which is in phase with the first electric signal 15. This signal portion passes a low-pass filter 37 of the in-phase-detector 16 and is amplified by an amplifier 38 of the in-phase-detector 16. The amplifier 38 provides the I-signal 18.

Moreover, the ascertaining device 10 comprises a quadrature-phase-detector 17 also coupled with the receiving apparatus, especially with the band pass filter 35. The quadrature-phase-detector 17 is configured to determine a Q-signal 19 in response to the second electric signal 14. For this purpose, the quadrature-phase-detector 17 comprises a quadrature demodulator 39 which is capable of determining a quadrature portion of the second electric signal 14. This quadrature portion passes a low-pass filter 40 and is amplified by an amplifier 41 of the quadrature-phase-detector 17. The amplifier 41 provides the Q-signal 19.

As can be further seen from Fig. 1, the I-signal 18 and the Q-signal 19 of the second electric signal 14 of the capacitive sensor elements 2 are subjected to an offset compensation 34. For this purpose, an offset compensation 42 for the I-signal 18 and an offset compensation apparatus 43 for the Q-signal 19 is provided. The offset compensation compensates for parasitic offsets in the capacitive sensor device 1 and allows further shifting a DC operating point, in order to maximize an operating range, especially with regard to use of an analogue-digital-converter. This may be used for further digital processing of the I-signal 18 and the Q-signal 19.

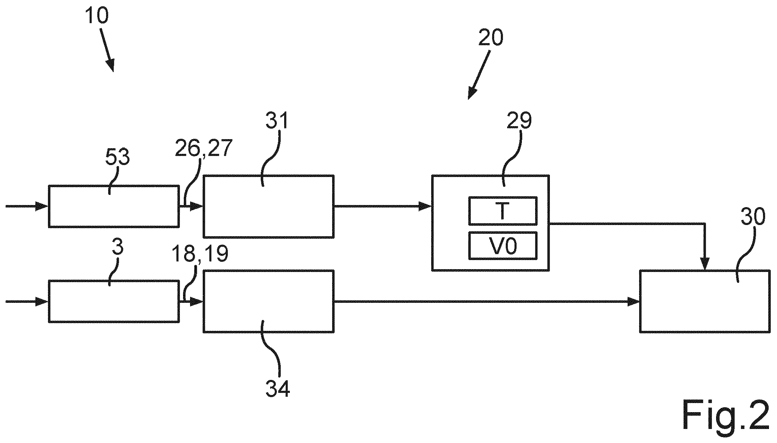

The compensated I-signal 18 and Q-signal 19 are then supplied to a further multiplexer 44 so that the I-signal 18 and the Q-signal 19 can be further processed as discussed below with regard to Fig. 2.

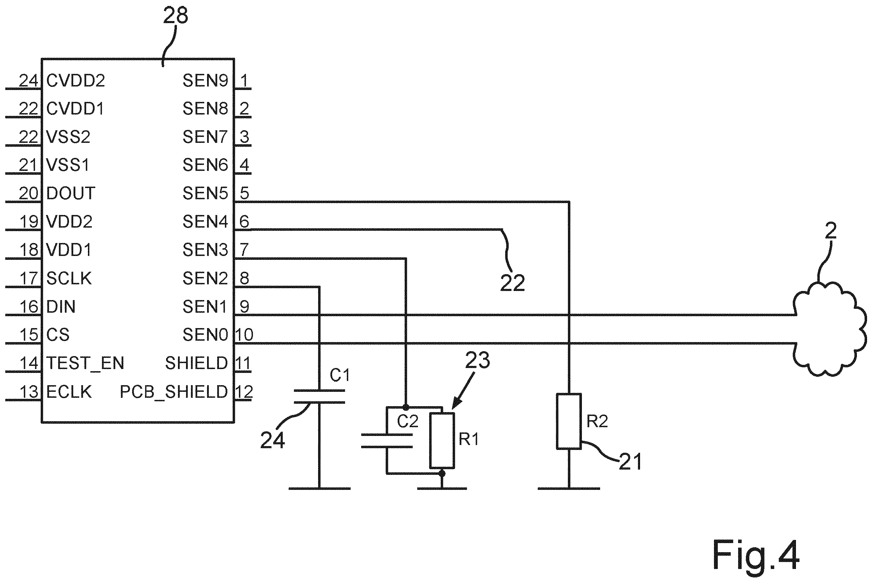

As can be seen from Fig. 4, the circuitry of Fig. 1 can be integrated in an integrated circuit that is arranged in a housing 28 having a respective number of pins. Especially, the housing 28 has at least one pin for electrically conducting any of the capacitive sensor elements 2. Moreover, as can be seen from Fig. 4, in the present case, the housing 28 also as four pins, which are connected with four different reference impedances 21, 22, 23, 24. Generally, for the purpose of the invention, only three reference impedances need to be necessary. However, the number of the reference impedances may be higher as in the present embodiment.

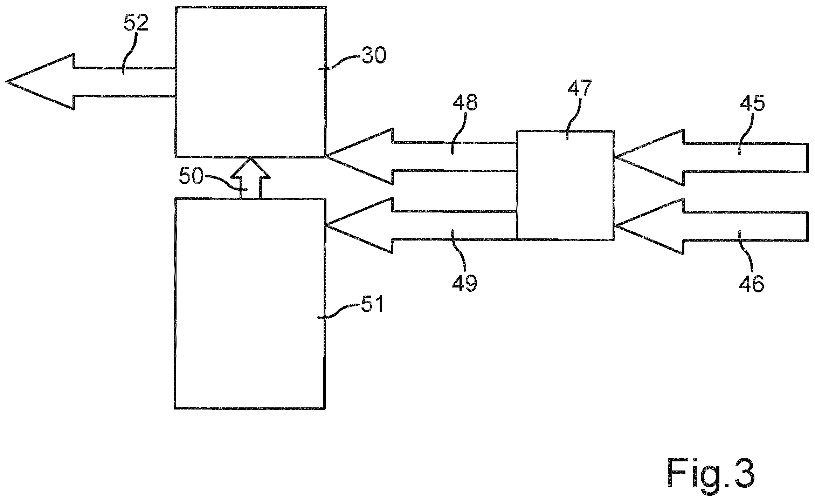

However, it should be noted that the input terminals of the reference impedances 21, 22, 23, 24 and the capacitive sensor elements 2 are operated in the same manner according to Fig. 1. However, in Fig. 1 the second electric signal of the reference impedances 21, 22, 23, 24 is indicated with the reference character 25, and the reference I-signal and the reference Q-signal are indicated by respective reference characters 26, 27. However, at the end of the circuitry according to Fig. 3, all signals are together multiplexed and can be received at the lines 3, 53 which provide respective input signals for the circuitry as shown and further discussed with regard to Fig. 2.

Generally, it should be noted that preferably the first and the second electric signals 14, 15 are analogous signals. However, these signals may be digitized for further processing.

Each of the reference impedances 21, 22, 23, 24 comprises generally a resistive part and a reactive part. In the present case, the reference impedance 21 comprises only a resistive part in form of a resistor R2. The reactive part is zero. Moreover, the reference impedance 22 is simply an open pin of the respective terminal of the housing 28. In this regard, this reference impedance 22 has a high resistive part and also a reactive part with the value of zero. The reference impedance 23 comprises a capacitor C2, which is connected in parallel with a resistor R1. Therefore, the reference impedance 23 has a resistive part and a reactive part, which may have a reasonable value. Finally, the reference impedance 24 comprises a capacitor C1 so that the resistive part is ad infinitum and the reactive part has a finite value. Therefore, the resistive part or the reactive part of one of the reference impedances 21, 22, 23, 24 differs from the respective values of the resistive part or the reactive part, respectively, of one of the other reference impedances 21, 22, 23, 24. As discussed below, this allows spanning of a virtual plane which may be used to calculate parameters of a transform apparatus, in order to provide transform of the I-signal 18 and the Q-signal 19 of the second electric signal 14.

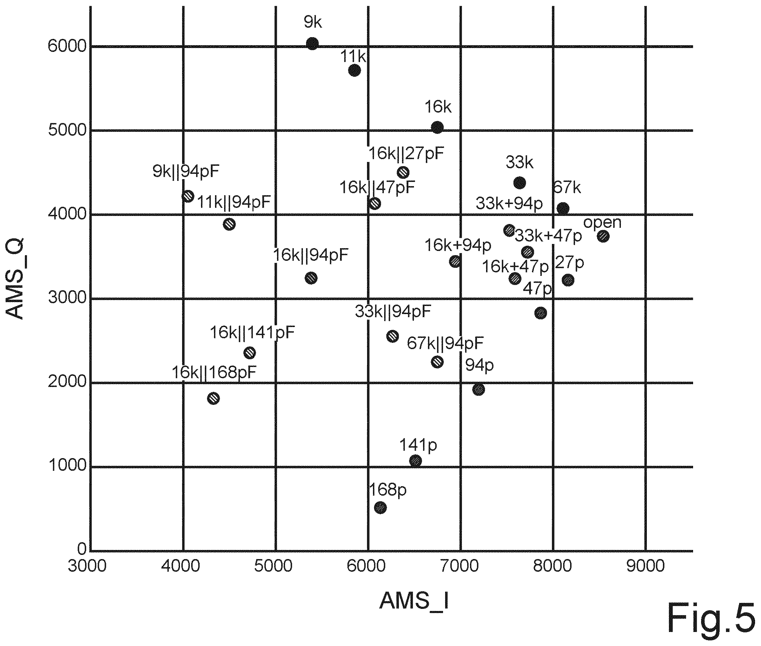

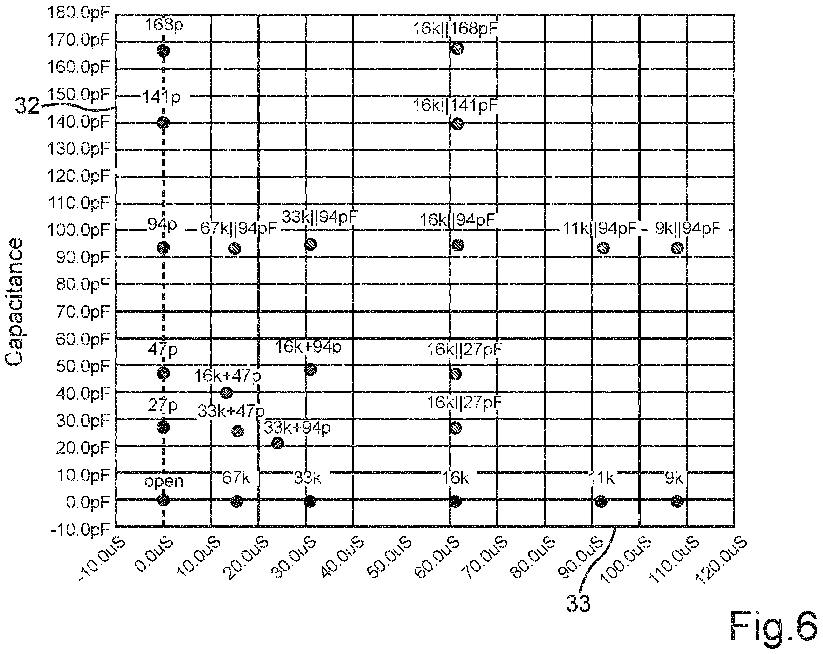

Fig. 2 shows a second portion of the ascertaining device 10, which deals with processing of the I-signals 18 and the Q-signals 19 based on a transform, which itself is determined by considering the reference I-signals 26 and the reference Q-signals 27. As can be seen from Fig. 2, the reference I-signals 26 and the reference Q-signals 27 are subjected to DC-offset-homogenisation 31. Then, these signals are processed, in order to determine parameters 29 of a transform apparatus 30. This processing will be discussed further below. The parameters 29 allow providing a transform with the transform apparatus 30 so that the I-signals 18 and the Q-signals 19 can be allocated to a respective capacitance value and a respective conductivity value. This is shown with regard to Fig. 5 and 6 below.

Fig. 5 shows a schematic diagram, wherein the ordinate is allocated to the Q-signal value and the abscissa is allocated to the I-signal value. As a parameter, impedances of the capacitive sensor elements 2 and the respective reference impedances 21, 22, 23, 24 are shown. As can be seen from the diagram according to Fig. 5, impedances having only a resistive part used to be aranged on a line diagonal falling with higher values of I-signals. Orthogonal thereto is a line allocated to impedances having only a reactive part. These both lines and the ordinate and the abscissa form an area of the impedances of the capacitive sensor elements 2. However, the I-signals 18 and the Q-signals 19 depend from temperature and further environmental effects.

The transform apparatus 30 allows providing a transform as shown in Fig. 6 so that the parameters as shown in Fig. 5 can be allocated to respective capacitance values and conductance values. Fig. 6 shows an ordinate 32 which is allocated to the capacitance value and an abscissa 33 which is allocated to the conductance value. As can be seen, impedances having only a resistive part are now located on a line parallel to the abscissa, wherein impedances having only a reactive part are positioned on a line parallel to the ordinate. This transform allows a determination apparatus 20 of the ascertaining device 10 to improve ascertaining the manual exertion so that thermal influences or environmental influences can be reduced and the reliability of ascertaining can be improved.

Fig. 3 further details the inventive concept. A first arrow 45 is allocated to the second electric signals 14 provided by the capacitive sensor device 1, which can be a steering wheel HOD mat. Moreover, a second arrow 46 is allocated to the second reference signals 25, which are provided by the reference impedances 21, 22, 23, 24, which are provided by fixed capacitors and fixed resistors as detailed above. These signals are supplied to an impedance sensor 47 which can be provided by a circuitry as detailed above with regard to Fig. 1. This circuitry provides I-signals 18 and Q-signals 19 as discussed above, which is indicated by a third arrow 48. Also, reference I-signals 26 and reference Q-signals 27 are provided by the impedance sensor 47, which is indicated by a fourth arrow 49. These values are supplied to a parameter determining apparatus 51, which determines the respective parameters, which are supplied to the transform apparatus 30 as detailed above, which is indicated by a fifth arrow 50. Especially, the parameter determining apparatus 51 can compute a transfer function to transform the I-signals 18 and the Q-signals 19 to respective capacitance values and conductance values as detailed above. These parameters 29 may be used by the transform apparatus 30 to get the corresponding capacitance values and conductivity values. The capacitance value in the present case is very robust against environment, whereas the I-signal 18 and the Q-signal 19 are rather unstable due to the impedance sensor sensitivity to temperature. Finally, a sixth arrow 52 shows that the respective capacitance values and conductivity values are provided for further ascertaining of manual exertion by the determination apparatus 20.

The following discussion is based on digital signal values.

For providing the transform, the following operations can be provided. The following equation is applicable for each channel that is each relevant terminal "sen..." of the circuitry according to Fig. 4 ${\left[\begin{matrix}I \\ Q\end{matrix}\right]}_{\begin{matrix}Measures from \\ AMS\end{matrix}} = {\left[\begin{matrix}T 11 & T 12 \\ T 21 & T 22\end{matrix}\right]}_{\begin{matrix}Transfer Matrix = \\ T\end{matrix}} \times {\left[\begin{matrix}G ∗ \\ C\end{matrix}\right]}_{\begin{matrix}Expected values \\ Z = impedance \\ C = capacitance\end{matrix}} + {\left[\begin{matrix}I 0 \\ Q 0\end{matrix}\right]}_{\begin{matrix}New origin = \\ V 0\end{matrix}}$

The transfer matrix 'T' and vector 'VO' are computed through linear interpolation using:
- Refrence Chanel 1 [G1; C1]
- Reference Chanel 2 [G2;C2]
- Reference Chanel 3 [G3;C3]

The 3 reference channels are used to guess T matrix and V0 matrix by solving the system: ${G}_{1} \times {T}_{11} + {C}_{1} \times {T}_{12} + {I}_{0} = {I}_{1}$ ${G}_{2} \times {T}_{11} + {C}_{2} \times {T}_{12} + {I}_{0} = {I}_{2}$ ${G}_{3} \times {T}_{11} + {C}_{3} \times {T}_{12} + {I}_{0} = {I}_{3}$ ${G}_{1} \times {T}_{21} + {C}_{1} \times {T}_{22} + {Q}_{0} = {Q}_{1}$ ${G}_{2} \times {T}_{21} + {C}_{2} \times {T}_{22} + {Q}_{0} = {Q}_{2}$ ${G}_{3} \times {T}_{21} + {C}_{3} \times {T}_{22} + {Q}_{0} = {Q}_{3}$

This includes the hypothesis that the 3 points are forming a plane.

The now known T matrix $\left[\begin{matrix}T 11 & T 12 \\ T 21 & T 22\end{matrix}\right]$ and V0 vector $\left[\begin{matrix}I 0 \\ Q 0\end{matrix}\right]$ can now be used to transform any Q-signal/I-signal pairs into conductivity/capacitance value by using the formula: ${\left[\begin{matrix}G ∗ \\ C\end{matrix}\right]}_{GC} = \frac{1}{det \left(T\right)} \times {\left[\begin{matrix}T 22 & - T 12 \\ - T 21 & T 11\end{matrix}\right]}_{T} \times {\left[\left[\begin{matrix}I \\ Q\end{matrix}\right]-\left[\begin{matrix}I 0 \\ Q 0\end{matrix}\right]\right]}_{Measure V 0}$

As can be seen from the above discussion, additional processing of the I-signal 18 and the Q-signal 19 enhances the reliability and the stability of ascertaining manual exertion.

The embodiments discussed above are provided only for further understanding of the invention and should not limit the scope.

## Claims

1. A method for ascertaining a manual exertion of a capacitive sensor device (1), wherein at least one capacitive sensor element (2) of the capacitive sensor device (1) is exposed to a sinewave-based first electric signal (15), wherein the at least one capacitive sensor element (2) provides a second electric signal (14) in response to exposition with the first electric signal (15), wherein the second electric signal (14) is input to an in-phase-detector (16), in order to provide an I-signal (18) in response to the second electric signal (14), which is in phase with the first electrical signal (15), and a quadrature-phase-detector (17), in order to provide a Q-signal (19) in response to the second electric signal (14), which phase is orthogonal to the first electrical signal (15), wherein the I-signal (18) and the Q-signal (19) are processed by a determination apparatus (20) in order to allow ascertaining the manual exertion, **characterized in that** at least three predetermined reference impedances are also exposed to the first electric signal, wherein the at least three predetermined reference impedances provide respective second electric reference signals which are input to the in-phase-detector and the quadrature-phase-detector, in order to provide respective reference I-signals and respective reference Q-signals, wherein the I-signal and the Q-signal of the second electric signal of the at least one capacitive sensor element, the reference I-signals and the reference Q-signals are processed by the determination apparatus, in order to ascertain the manual exertion additionally depending on the reference I-signals and the reference Q-signals.

2. The method according to claim 1,
**characterized in that** the first electric signal (15) is a voltage-based signal and the second electric signal (14) is a current-based signal.

3. The method according to anyone of the preceding claims,
**characterized in that** the first and the second electric signals (14, 15) are analogous signals.

4. The method according to anyone of the preceding claims,
**characterized in that** each of the reference impedances (21, 22, 23, 24) comprises a resistive part and a reactive part.

5. The method according to claim 4,
**characterized in that** at least a value of the resistive part or the reactive part of one of the reference impedances (21, 22, 23, 24) differs from the respective values of the resistive part or the reactive part, respectively, of one of the other reference impedances (21, 22, 23, 24).

6. The method according to anyone of the preceding claims,
**characterized in that** the in-phase-detector (16) processes the second electric signal (14, 25) such that an in-phase signal portion of the second electric signal (14, 25) is determined for providing the I-signal (18, 26).

7. The method according to anyone of the preceding claims,
**characterized in that** the quadrature-phase-detector (17) processes the second signal (19, 27) such that a quadrature-phase signal portion of the second signal (14, 25) is determined for providing the Q-signal (19, 27).

8. The method according to anyone of the preceding claims,
**characterized in that** parameters (29) of a transform apparatus (30) are determined dependent on the reference I-signals (26), reference Q-signals (27) and respective values of the predetermined reference impedances (21, 22, 23, 24).

9. The method according to claim 9,
**characterized in that** the reference I-signals (26) and reference Q-signals (27) are subjected to an offset compensation (31).

10. The method according to anyone of the preceding claims,
**characterized in that** the I-signal (18) and the Q-signal (19) of the second electric signal (14) of the at least one capacitive sensor element (2) is processed by the transform apparatus (20), in order to determine a respective capacity value (32) and a respective conductivity value (33) with regard to the second electric signal (14) of the at least one capacitive sensor element (2).

11. The method according to anyone of the preceding claims,
**characterized in that** the I-signal (18) and the Q-signal (19) of the second electric signal (14) of the at least one capacitive sensor element (2) are subjected to the offset compensation (34).

12. The method according to anyone of the claims 10 or 11,
**characterized in that** the manual exertion is ascertained based on the respective capacity value (32) and a respective conductivity value (33) related to the second electric signal (14) of the at least one capacitive sensor element (2).

13. A computer program product including a program for a computing apparatus, comprising software code portions of a computer program for performing the steps of a method according to anyone of the preceding claims, when the computer program is run on the computing apparatus.

14. An ascertaining device (10) for ascertaining a manual exertion of a capacitive sensor device (1), wherein the ascertaining device (10) is configured to be coupled to at least one capacitive sensor element (2) of the capacitive sensor device (1), the ascertaining device (10) comprising:
- a signal generator (11) for generating a sinewave-based first electric signal (15), wherein the signal generator (11) is further configured to expose the at least one capacitive sensor element (2) of the capacitive sensor device (1) to the first electric signal (15),
- a receiving apparatus (13) configured to receive a second electric signal (14) from the at least one capacitive sensor element (2) provided in response to exposition with the first electric signal (15),
- an in-phase-detector (16) coupled with the receiving apparatus (13), wherein the in-phase-detector (16) is configured to determine an I-signal (18) in response to the second electric signal (14),
- a quadrature-phase-detector (17) coupled with the receiving apparatus (13), wherein the quadrature-phase-detector (17) is configured to determine a Q-signal (19) in response to the second electric signal (14), and
- a determination apparatus (20) coupled with the in-phase-detector (16) and the quadrature-phase-detector (17), wherein the determination apparatus (20) is configured to process the I-signal (18) and the Q-signal (19) of the respective second signal (14) of the at least one capacitive sensor element (2), in order to allow ascertaining the manual exertion,
**characterized in that**
the ascertaining device (10) is further configured to be coupled to at least three predetermined reference impedances (21, 22, 23, 24), wherein the signal generator (11) is configured to expose the at least three predetermined reference impedances (21, 22, 23, 24) to the first electric signal (15) and the receiving apparatus (13) is configured to receive respective second electric reference signals (25) from the at least three predetermined reference impedances (21, 22, 23, 24) supplied to the in-phase-detector (16) and the quadrature-phase-detector (17), in order to provide respective reference I-signals (26) and respective reference Q-signals (27), wherein the determination apparatus (20) is further configured to process the I-signal (18) and the Q-signal (19) of the second electric signal (14) of the at least one capacitive sensor element (2), the reference I-signals (26) and the reference Q-signals (27), in order to allow ascertaining the manual exertion additionally depending on the reference I-signals (26) and the reference Q-signals (27).

15. The ascertaining device according to claim 14,
**characterized by** a housing (28) with at least four input terminals configured to be connected with a respective one of the at least three reference impedances (21, 22, 23, 24) and the at least one capacitive sensor element (2) of the capacitive sensor device (1).

## Patentansprüche

1. Verfahren zur Ermittlung einer manuellen Betätigung einer kapazitiven Sensorvorrichtung (1), wobei mindestens ein kapazitives Sensorelement (2) der kapazitiven Sensorvorrichtung (1) einem sinuswellenbasierten ersten elektrischen Signal (15) ausgesetzt wird, wobei das mindestens eine kapazitive Sensorelement (2) ein zweites elektrisches Signal (14) als Reaktion auf die Exposition mit dem ersten elektrischen Signal (15) bereitstellt, wobei das zweite elektrische Signal (14) in einen Phasengleichdetektor (16) eingespeist wird, um ein I-Signal (18) als Reaktion auf das zweite elektrische Signal (14) bereitzustellen, das mit dem ersten elektrischen Signal (15) in Phase ist, und einen Quadraturphasendetektor (17), um ein Q-Signal (19) als Reaktion auf das zweite elektrische Signal (14) bereitzustellen, dessen Phase orthogonal zum ersten elektrischen Signal (15) ist, wobei das I-Signal (18) und das Q-Signal (19) von einer Bestimmungsvorrichtung (20) verarbeitet werden, um die Ermittlung der manuellen Betätigung zu ermöglichen, **dadurch gekennzeichnet, dass** mindestens drei vorbestimmte Referenzimpedanzen ebenfalls dem ersten elektrischen Signal ausgesetzt werden, wobei die mindestens drei vorbestimmten Referenzimpedanzen jeweilige zweite elektrische Referenzsignale bereitstellen, die in den Phasengleichdetektor und den Quadraturphasendetektor eingespeist werden, um jeweilige Referenz-I-Signale und jeweilige Referenz-Q-Signale bereitzustellen, wobei das I-Signal und das Q-Signal des zweiten elektrischen Signals des mindestens einen kapazitiven Sensorelements, die Referenz-I-Signale und die Referenz-Q-Signale von der Bestimmungsvorrichtung verarbeitet werden, um die manuelle Betätigung zusätzlich in Abhängigkeit von den Referenz-I-Signalen und den Referenz-Q-Signalen zu ermitteln.

2. Verfahren nach Anspruch 1, **dadurch gekennzeichnet, dass** das erste elektrische Signal (15) ein spannungsbasiertes Signal und das zweite elektrische Signal (14) ein strombasiertes Signal ist.

3. Verfahren nach einem der vorhergehenden Ansprüche, **dadurch gekennzeichnet, dass** das erste und das zweite elektrische Signal (14, 15) analoge Signale sind.

4. Verfahren nach einem der vorhergehenden Ansprüche, **dadurch gekennzeichnet, dass** jede der Referenzimpedanzen (21, 22, 23, 24) einen resistiven Teil und einen reaktiven Teil umfasst.

5. Verfahren nach Anspruch 4, **dadurch gekennzeichnet, dass** sich mindestens ein Wert des resistiven Teils oder des reaktiven Teils einer der Referenzimpedanzen (21, 22, 23, 24) von den jeweiligen Werten des resistiven Teils bzw. des reaktiven Teils einer der anderen Referenzimpedanzen (21, 22, 23, 24) unterscheidet.

6. Verfahren nach einem der vorhergehenden Ansprüche, **dadurch gekennzeichnet, dass** der Phasengleichdetektor (16) das zweite elektrische Signal (14, 25) so verarbeitet, dass ein phasengleicher Signalanteil des zweiten elektrischen Signals (14, 25) zur Bereitstellung des I-Signals (18, 26) bestimmt wird.

7. Verfahren nach einem der vorhergehenden Ansprüche, **dadurch gekennzeichnet, dass** der Quadraturphasendetektor (17) das zweite Signal (19, 27) so verarbeitet, dass ein Quadraturphasensignalanteil des zweiten Signals (14, 25) zur Bereitstellung des Q-Signals (19, 27) bestimmt wird.

8. Verfahren nach einem der vorhergehenden Ansprüche, **dadurch gekennzeichnet, dass** Parameter (29) einer Transformationsvorrichtung (30) in Abhängigkeit von den Referenz-I-Signalen (26), Referenz-Q-Signalen (27) und jeweiligen Werten der vorbestimmten Referenzimpedanzen (21, 22, 23, 24) bestimmt werden.

9. Verfahren nach Anspruch 9, **dadurch gekennzeichnet, dass** die Referenz-I-Signale (26) und Referenz-Q-Signale (27) einer Offsetkompensation (31) unterzogen werden.

10. Verfahren nach einem der vorhergehenden Ansprüche, **dadurch gekennzeichnet, dass** das I-Signal (18) und das Q-Signal (19) des zweiten elektrischen Signals (14) des mindestens einen kapazitiven Sensorelements (2) von der Transformationsvorrichtung (20) verarbeitet wird, um einen jeweiligen Kapazitätswert (32) und einen jeweiligen Leitfähigkeitswert (33) in Bezug auf das zweite elektrische Signal (14) des mindestens einen kapazitiven Sensorelements (2) zu bestimmen.

11. Verfahren nach einem der vorhergehenden Ansprüche, **dadurch gekennzeichnet, dass** das I-Signal (18) und das Q-Signal (19) des zweiten elektrischen Signals (14) des mindestens einen kapazitiven Sensorelements (2) der Offsetkompensation (34) unterzogen werden.

12. Verfahren nach einem der Ansprüche 10 oder 11, **dadurch gekennzeichnet, dass** die manuelle Betätigung auf der Grundlage des jeweiligen Kapazitätswerts (32) und eines jeweiligen Leitfähigkeitswerts (33) in Bezug auf das zweite elektrische Signal (14) des mindestens einen kapazitiven Sensorelements (2) ermittelt wird.

13. Computerprogrammprodukt mit einem Programm für eine Rechenvorrichtung, umfassend Softwarecodeabschnitte eines Computerprogramms zur Durchführung der Schritte eines Verfahrens nach einem der vorhergehenden Ansprüche, wenn das Computerprogramm auf der Rechenvorrichtung ausgeführt wird.

14. Ermittlungsvorrichtung (10) zur Ermittlung einer manuellen Betätigung einer kapazitiven Sensorvorrichtung (1), wobei die Ermittlungsvorrichtung (10) konfiguriert ist, um mit mindestens einem kapazitiven Sensorelement (2) der kapazitiven Sensorvorrichtung (1) gekoppelt zu werden, wobei die Ermittlungsvorrichtung (10) umfasst:
- einen Signalgenerator (11) zum Erzeugen eines sinuswellenbasierten ersten elektrischen Signals (15), wobei der Signalgenerator (11) ferner konfiguriert ist, das mindestens eine kapazitive Sensorelement (2) der kapazitiven Sensorvorrichtung (1) dem ersten elektrischen Signal (15) auszusetzen,
- eine Empfangsvorrichtung (13), die konfiguriert ist, ein zweites elektrisches Signal (14) von dem mindestens einen kapazitiven Sensorelement (2) zu empfangen, das als Reaktion auf die Exposition mit dem ersten elektrischen Signal (15) bereitgestellt wird,
- einen Phasengleichdetektor (16), der mit der Empfangsvorrichtung (13) gekoppelt ist, wobei der Phasengleichdetektor (16) konfiguriert ist, ein I-Signal (18) als Reaktion auf das zweite elektrische Signal (14) zu bestimmen,
- einen Quadraturphasendetektor (17), der mit der Empfangsvorrichtung (13) gekoppelt ist, wobei der Quadraturphasendetektor (17) konfiguriert ist, ein Q-Signal (19) als Reaktion auf das zweite elektrische Signal (14) zu bestimmen, und
- eine Bestimmungsvorrichtung (20), die mit dem Phasengleichdetektor (16) und dem Quadraturphasendetektor (17) gekoppelt ist, wobei die Bestimmungsvorrichtung (20) konfiguriert ist, das I-Signal (18) und das Q-Signal (19) des jeweiligen zweiten Signals (14) des mindestens einen kapazitiven Sensorelements (2) zu verarbeiten, um die Ermittlung der manuellen Betätigung zu ermöglichen, **dadurch gekennzeichnet, dass** die Ermittlungsvorrichtung (10) ferner konfiguriert ist, mit mindestens drei vorbestimmten Referenzimpedanzen (21, 22, 23, 24) gekoppelt zu werden, wobei der Signalgenerator (11) konfiguriert ist, die mindestens drei vorbestimmten Referenzimpedanzen (21, 22, 23, 24) dem ersten elektrischen Signal (15) auszusetzen, und die Empfangsvorrichtung (13) konfiguriert ist, jeweilige zweite elektrische Referenzsignale (25) von den mindestens drei vorbestimmten Referenzimpedanzen (21, 22, 23, 24) zu empfangen, die dem Phasengleichdetektor (16) und dem Quadraturphasendetektor (17) zugeführt werden, um jeweilige Referenz-I-Signale (26) und jeweilige Referenz-Q-Signale (27) bereitzustellen, wobei die Bestimmungsvorrichtung (20) ferner konfiguriert ist, das I-Signal (18) und das Q-Signal (19) des zweiten elektrischen Signals (14) des mindestens einen kapazitiven Sensorelements (2), die Referenz-I-Signale (26) und die Referenz-Q-Signale (27) zu verarbeiten, um die Ermittlung der manuellen Betätigung zusätzlich in Abhängigkeit von den Referenz-I-Signalen (26) und den Referenz-Q-Signalen (27) zu ermöglichen.

15. Ermittlungsvorrichtung nach Anspruch 14, **gekennzeichnet durch** ein Gehäuse (28) mit mindestens vier Eingangsanschlüssen, die konfiguriert sind, um mit einer jeweiligen der mindestens drei Referenzimpedanzen (21, 22, 23, 24) und dem mindestens einen kapazitiven Sensorelement (2) der kapazitiven Sensorvorrichtung (1) verbunden zu werden.

## Revendications

1. Procédé pour déterminer une action manuelle d'un dispositif de capteur capacitif (1), dans lequel au moins un élément de capteur capacitif (2) du dispositif de capteur capacitif (1) est exposé à un premier signal électrique (15) basé sur une onde sinusoïdale, dans lequel l'au moins un élément de capteur capacitif (2) fournit un deuxième signal électrique (14) en réponse à l'exposition au premier signal électrique (15), dans lequel le deuxième signal électrique (14) est introduit dans un détecteur en phase (16), afin de fournir un signal I (18) en réponse au deuxième signal électrique (14), qui est en phase avec le premier signal électrique (15), et un détecteur en quadrature de phase (17), afin de fournir un signal Q (19) en réponse au deuxième signal électrique (14), dont la phase est orthogonale au premier signal électrique (15), dans lequel le signal I (18) et le signal Q (19) sont traités par un appareil de détermination (20) afin de permettre de déterminer l'action manuelle, **caractérisé en ce qu'**au moins trois impédances de référence prédéterminées sont également exposées au premier signal électrique, dans lequel les au moins trois impédances de référence prédéterminées fournissent des deuxièmes signaux électriques de référence respectifs qui sont introduits dans le détecteur en phase et le détecteur en quadrature de phase, afin de fournir des signaux I de référence respectifs et des signaux Q de référence respectifs, dans lequel le signal I et le signal Q du deuxième signal électrique de l'au moins un élément de capteur capacitif, les signaux I de référence et les signaux Q de référence sont traités par l'appareil de détermination, afin de déterminer l'action manuelle en fonction additionnellement des signaux I de référence et des signaux Q de référence.

2. Procédé selon la revendication 1, **caractérisé en ce que** le premier signal électrique (15) est un signal basé sur la tension et le deuxième signal électrique (14) est un signal basé sur le courant.

3. Procédé selon l'une quelconque des revendications précédentes, **caractérisé en ce que** les premier et deuxième signaux électriques (14, 15) sont des signaux analogiques.

4. Procédé selon l'une quelconque des revendications précédentes, **caractérisé en ce que** chacune des impédances de référence (21, 22, 23, 24) comprend une partie résistive et une partie réactive.

5. Procédé selon la revendication 4, **caractérisé en ce qu'**au moins une valeur de la partie résistive ou de la partie réactive de l'une des impédances de référence (21, 22, 23, 24) diffère des valeurs respectives de la partie résistive ou de la partie réactive, respectivement, de l'une des autres impédances de référence (21, 22, 23, 24).

6. Procédé selon l'une quelconque des revendications précédentes, **caractérisé en ce que** le détecteur en phase (16) traite le deuxième signal électrique (14, 25) de telle sorte qu'une portion de signal en phase du deuxième signal électrique (14, 25) est déterminée pour fournir le signal I (18, 26).

7. Procédé selon l'une quelconque des revendications précédentes, **caractérisé en ce que** le détecteur en quadrature de phase (17) traite le deuxième signal (19, 27) de telle sorte qu'une portion de signal en quadrature de phase du deuxième signal (14, 25) est déterminée pour fournir le signal Q (19, 27).

8. Procédé selon l'une quelconque des revendications précédentes, **caractérisé en ce que** des paramètres (29) d'un appareil de transformation (30) sont déterminés en fonction des signaux I de référence (26), des signaux Q de référence (27) et des valeurs respectives des impédances de référence prédéterminées (21, 22, 23, 24).

9. Procédé selon la revendication 9, **caractérisé en ce que** les signaux I de référence (26) et les signaux Q de référence (27) sont soumis à une compensation de décalage (31).

10. Procédé selon l'une quelconque des revendications précédentes, **caractérisé en ce que** le signal I (18) et le signal Q (19) du deuxième signal électrique (14) de l'au moins un élément de capteur capacitif (2) est traité par l'appareil de transformation (20), afin de déterminer une valeur de capacité respective (32) et une valeur de conductivité respective (33) en ce qui concerne le deuxième signal électrique (14) de l'au moins un élément de capteur capacitif (2).

11. Procédé selon l'une quelconque des revendications précédentes, **caractérisé en ce que** le signal I (18) et le signal Q (19) du deuxième signal électrique (14) de l'au moins un élément de capteur capacitif (2) sont soumis à la compensation de décalage (34).

12. Procédé selon l'une quelconque des revendications 10 ou 11, **caractérisé en ce que** l'action manuelle est déterminée sur la base de la valeur de capacité respective (32) et d'une valeur de conductivité respective (33) liée au deuxième signal électrique (14) de l'au moins un élément de capteur capacitif (2).

13. Produit de programme informatique comprenant un programme pour un appareil informatique, comprenant des portions de code logiciel d'un programme informatique pour exécuter les étapes d'un procédé selon l'une quelconque des revendications précédentes, lorsque le programme informatique est exécuté sur l'appareil informatique.

14. Dispositif de détermination (10) pour déterminer une action manuelle d'un dispositif de capteur capacitif (1), dans lequel le dispositif de détermination (10) est configuré pour être couplé à au moins un élément de capteur capacitif (2) du dispositif de capteur capacitif (1), le dispositif de détermination (10) comprenant :
- un générateur de signal (11) pour générer un premier signal électrique (15) basé sur une onde sinusoïdale, dans lequel le générateur de signal (11) est en outre configuré pour exposer l'au moins un élément de capteur capacitif (2) du dispositif de capteur capacitif (1) au premier signal électrique (15),
- un appareil de réception (13) configuré pour recevoir un deuxième signal électrique (14) de l'au moins un élément de capteur capacitif (2) fourni en réponse à l'exposition au premier signal électrique (15),
- un détecteur en phase (16) couplé à l'appareil de réception (13), dans lequel le détecteur en phase (16) est configuré pour déterminer un signal I (18) en réponse au deuxième signal électrique (14),
- un détecteur en quadrature de phase (17) couplé à l'appareil de réception (13), dans lequel le détecteur en quadrature de phase (17) est configuré pour déterminer un signal Q (19) en réponse au deuxième signal électrique (14), et
- un appareil de détermination (20) couplé au détecteur en phase (16) et au détecteur en quadrature de phase (17), dans lequel l'appareil de détermination (20) est configuré pour traiter le signal I (18) et le signal Q (19) du deuxième signal respectif (14) de l'au moins un élément de capteur capacitif (2), afin de permettre de déterminer l'action manuelle, **caractérisé en ce que** le dispositif de détermination (10) est en outre configuré pour être couplé à au moins trois impédances de référence prédéterminées (21, 22, 23, 24), dans lequel le générateur de signal (11) est configuré pour exposer les au moins trois impédances de référence prédéterminées (21, 22, 23, 24) au premier signal électrique (15) et l'appareil de réception (13) est configuré pour recevoir des deuxièmes signaux électriques de référence respectifs (25) des au moins trois impédances de référence prédéterminées (21, 22, 23, 24) fournis au détecteur en phase (16) et au détecteur en quadrature de phase (17), afin de fournir des signaux I de référence respectifs (26) et des signaux Q de référence respectifs (27), dans lequel l'appareil de détermination (20) est en outre configuré pour traiter le signal I (18) et le signal Q (19) du deuxième signal électrique (14) de l'au moins un élément de capteur capacitif (2), les signaux I de référence (26) et les signaux Q de référence (27), afin de permettre de déterminer l'action manuelle en fonction additionnellement des signaux I de référence (26) et des signaux Q de référence (27).

15. Dispositif de détermination selon la revendication 14, **caractérisé par** un boîtier (28) avec au moins quatre bornes d'entrée configurées pour être connectées à une impédance respective des au moins trois impédances de référence (21, 22, 23, 24) et à l'au moins un élément de capteur capacitif (2) du dispositif de capteur capacitif (1).
